# EUROPEAN PATENT APPLICATION

(11) **EP 3 334 035 A1**
(43) Date of publication of application: **13.06.2018**
(21) Application number: 16203565.3
(22) Date of filing: 12.12.2016
(51) Int. Cl.: H02S 50/10, H01R 13/22, H02S 40/34, H01R 13/193, B25J 19/00

(54) **A SOLAR MODULE CONNECTING APPARATUS**

(71) Applicant: Pasan SA, 2000 Neuchâtel (CH)
(72) Inventor: CLERC, Charles, 2000 Neuchâtel (CH); PRINCE, Slim Ferdinand, 1588 Cudrefin (CH); FAKHFOURI, Vahid, 1032 Romanel-sur-Lausanne (CH)
(74) Representative: Patentbüro Paul Rosenich AG

(57) **Abstract**

The invention relates to a solar module connecting apparatus (10) for electrically connecting a solar module (20) with a measurement device (24), comprising
- a junction unit (1) for being temporarily electrically connected to the solar module (20) and having at least one first electrical contact (11), and
- at least one contacting device (2) having at least one second electrical contact (12) for temporarily contacting the at least one first electrical contact (11) of the junction unit (1),
wherein the contacting device (2) may be brought from a noncontacting state into a contacting state, in which the at least one first electrical contact (11) abuts against the at least one second electrical contact (12),
characterized in that the contacting device (2) comprises holding means (14) for exerting a holding force on at least one part, preferably on the at least one first electrical contact (11), of the junction unit (1), wherein the holding means (14) may be brought from a releasing state into a holding state.

## Description

The invention relates to a solar module connecting apparatus for electrically connecting a solar module with a measurement device according to the preamble of claim 1. The invention also relates to a solar module testing apparatus for testing a solar module and to a method of electrically connecting a solar module with a measurement device.

For testing purposes it is necessary to electrically connect a solar module with a measurement device. Usually a solar module has a permanent junction box which will be used in operation of the solar module. The permanent junction box also allows the electrically contacting for testing purposes.

CN202083718U discloses a quick connector (also called: temporary junction unit) for electrically connecting a solar module, the quick connector comprising an electrical interface with three contacts and sockets for connecting the quick connector with a (permanent) junction box of the solar module by means of cables. Testing equipment is pressed with its contacts against the electrical interface of the quick connector in order to establishing an electrical connection. The quick connector also comprises a mechanical locking block. The quick connector is placed on the corner of a solar module and temporarily fixed to the connector by means of the locking block.

CN104181346A and CN204116385U disclose a module for testing an assembly junction box, comprising a module body provided with copper pieces contacted with probes a tester. The copper pieces are connected with a positive connecting wire and a negative connecting wire to be connected with connecting wires on the junction box.

As can be seen e.g. from CN202083718U the solar module has a permanent junction box which stays permanently assembled within the solar module. Such a permanent junction box is needed in order to contact the solar module for operation. In contrast to the permanent junction box, the temporary junction unit is added for testing purposes and will be removed again when testing procedures are finished.

Also known from prior art are temporary junction units which are placed on the solar module, wherein the bottom of the junction unit abuts against the surface of the solar module and the top of the junction unit has (first) electrical contacts. A connecting device is lowered from above and pressed with its (second) electrical contacts against the (first) electrical contacts of the junction unit. Thereby a considerable force is exerted to the solar module causing bending or even damage of the solar module. Moreover, reproducibility of the testing measurements is very low, since the contact force between the (first) electrical contacts of the temporary junction unit and the (second) electrical contacts of the contacting device may not be large enough to prevent damage to the solar module.

The object of the invention is to overcome these problems and to provide a connecting apparatus allowing the contacting of the junction unit in a reliable and reproducible manner and without negative impacts on the solar module. The connecting procedure (i.e. connecting the solar module with a measurement device) as well as the de-connecting procedure should be time-saving and free from any complications. The contacting apparatus should allow different types of test measurements such as measurements of I-V curves, electroluminescence measurements, high potential tests (Hipot-measurements), etc. The quality of the electrical contact (i.e. low contact resistance) between the first electrical contact(s) of the junction unit and the second electrical contact(s) of the contacting device should be high and reproducible.

The object is achieved by a solar module connecting apparatus as mentioned at the beginning in that the contacting device comprises holding means for exerting a holding force on at least one part, preferably on the at least one first electrical contact, of the junction unit, wherein the holding means may be brought from a releasing state into a holding state.

The holding means ensures a defined force transmission from the contacting device to the junction unit. The holding force exerted by the holding means on the junction unit prevents negative mechanical impacts on the solar module. Particularly, the holding means considerably reduces or even prevents introduction of forces from the contacting device via the junction unit to the solar module. With other words: the holding means is adapted to compensate - at least partially, preferably completely - forces transmitted from the second electrical contact(s) to the first electrical contact(s). The contacting device thus - partially or essentially completely - absorbs the contact force between the first and second electrical contact(s). The contacting device may e.g. compensate the exerted force with a counterforce in order to avoid pressure/load on the module.

In the holding state of the holding means (i.e. the holding means exerts - by means of an actuator - a holding force on at least a part of the junction unit), the contacting device is already or may be electrically connected to the junction unit.

In a first embodiment the second electrical contact(s) are integrally formed within the holding means. In the holding state the second electrical contact(s) automatically abut against the first electrical contact(s). In a second embodiment the second electrical contact(s) are independent from the holding means. Here, the second electrical contact(s) may be brought or pressed against the first electrical contacts by means of a separate actuator, at the same time but also after the holding means has been brought into the holding state.

Usually the junction unit has a housing. Within the housing there is an electrical connection between the first electrical contact(s) and the connections (e.g. sockets or cable tails) for connecting the solar module (via its permanent junction box).

Preferably, the material used for the first and/or second electrical contact(s) is/are made in ARCAP-manner (corrosion-resistant, good electrical properties).

Preferably, the connecting apparatus comprises at least one cable for connecting the (temporary) junction unit of the connecting apparatus with a (permanent) junction box of the solar module. The at least one cable may be - on its one end - attached to or integrally formed with the (temporary) junction unit and - on its other end - connected to the (permanent) junction box of the solar module.

The solar module may be any kind of module, such as a solar cell module or a thin film module.

Usually the testing procedure of a solar module comprises measurements several testing stations. At the beginning, the junction unit of the connecting apparatus is placed on and electrically connected to the solar module (via the permanent junction box of the solar module). In each testing station there is mounted a contacting device, usually above the solar module support. The junction unit travels together with the solar module from one testing station to another testing station. In each testing station a contacting device temporarily contacts the junction unit. After a certain measurement is finished the contacting device is brought into a non-contacting state and the solar module travels to the next testing station.

In a preferred embodiment the at least one second electrical contact is formed on the holding means, wherein preferably the second electrical contact is detachably mounted to the holding means. Here, the holding means acts with the second electrical contact(s) directly on the first electrical contact(s). I.e. the contact force between first and second electrical contacts is dependent from the holding force and thus well-defined and reproducible.

In a preferred embodiment the holding means is formed by a gripper, preferably a clamping-type gripper or an attracting-type gripper. In both cases the holding force is well defined by the clamping force or attracting force.

In a preferred embodiment the gripper is a mechanical gripper having gripper arms moveable relative to each other, wherein preferably the at least one second electrical contact is formed on at least one of the gripper arms, preferably on a side facing the other gripper arm. This allows a simple constructional design. Moreover, the holding means may simply grip the first electrical contact(s), thereby automatically establishing an electrical connection. In the releasing (i.e. not activated) state of the holding means, the gripper arms may rotate away from each other, e.g. by at least 180°, to avoid collision when the solar module comes into or travels away from the testing station.

It is preferred, if the direction of the gripping force exerted by the mechanical gripper is essentially parallel to the bottom of the junction unit (and thus parallel to the surface of the solar module). With such a 'lateral' contacting there is no adverse impact (stress/damage) on the solar module (and the encapsulated solar cells).

In a preferred embodiment the gripper is a suction gripper, wherein preferably the at least one second electrical contact is formed in the circumferential region and/or on the inside of a suction cup of the suction gripper. A suction gripper allows exerting an attracting force onto the junction unit, wherein the attracting force has a direction facing away from the solar module. Here, load on the solar module may be eliminated or considerably reduced.

In a preferred embodiment the gripper is a magnetic, preferably an electromagnetic gripper, wherein preferably the at least one second electrical contact is part of or connected to the core of a coil of the electromagnetic gripper. Here, the same advantages may be achieved: defined holding and contacting force, prevention of negative impacts on the solar module and simple actuation of the holding means.

In the case of a suction gripper or a magnetic gripper it is preferred, that the attracting force exerted by the gripper is essentially perpendicular to the bottom of the junction unit (and thus perpendicular to the surface of the solar module). Here, the junction unit is attracted away from the solar module, preventing any adverse impact on the solar module.

In a preferred embodiment the holding means comprises at least one actuator, particularly a motor, a cylinder, a valve, a controllable electrical switch or an electromagnet, for bringing the holding means from the releasing state into the holding state.

In a preferred embodiment the junction unit has at least two, preferably at least four, - preferably at least partially independent - first electrical contacts, wherein preferably an electrical insulation layer is formed between two first electrical contacts, and/or wherein the contacting device has at least two, preferably at least four, - preferably at least partially independent - second electrical contacts, wherein preferably an electrical insulation layer is formed between two second electrical contacts. The contacts are provided in an exposed position, preferably on the top of the junction unit and/or protruding from the housing of the junction unit.

Including four independent, preferably vertical, contacts allows for example to perform a current-voltage (I-V) measurement. Moreover, two additional contacts (plates) may be provided for electroluminescence and/or Hipot measurements.

Four independent contacts also allow performing Kelvin (4 points) measurement method to get a high repeatability and reliability of the measurement.

It is not necessary that all contacts (or their contact surfaces) have the same orientation. It would be e.g. possible that at least one of the (first or second) electrical contacts is inclined with respect to another electrical contact, e.g. by 90°.

In a preferred embodiment the contacting device has at least two second electrical contacts which are associated to one of the first electrical contacts. I.e. in the contacting state the two second electrical contacts abut against the one first electrical contact. In such a manner deviations in the contact resistance may be accounted for by means of a corresponding measurement circuit.

In a preferred embodiment the junction unit has a housing from which the at least one first electrical contact protrudes away, wherein preferably the height of the at least one first electrical contact is larger than the height of the housing and/or the width of the at least one first electrical contact is smaller than its height. Such an embodiment is particularly suitable for a mechanical gripper as holding means, since the exposed first electrical contacts may be easily gripped between gripper arms (also called: gripper fingers). However, in an alternate embodiment the height of the first electrical contacts may be smaller than their width. "Height" is the dimension of the contacts in direction of protruding-away (from the housing).

In a preferred embodiment the at least one first electrical contact has a contact surface which extends transverse, preferably perpendicular, to the bottom of the junction unit and/or wherein the at least one first electrical contact is plate-shaped. Here, also a mechanical gripper as holding means is preferred.

In a preferred embodiment the junction unit comprises fixing means, preferably a suction cup, a magnet, a hook, a snap-on device or an adhesive strip, for temporarily fixing the junction unit on a solar module, wherein preferably the junction unit comprises an operating element which is coupled to the fixing means for activating and/or releasing the fixing means. Here, the position of the junction unit on the solar module is guaranteed throughout the testing procedure.

In a preferred embodiment the junction unit comprises sockets, preferably formed in a side wall of the junction unit, and/or cable tails for connecting the junction unit by means of a cable with the solar module.

In a preferred embodiment the junction unit comprises an identification code, preferably in form of a bar code and/or a RFID, wherein preferably the contacting device comprises a code reader.

Preferably, the junction unit comprises a controller, preferably in communication with the at least one first electrical contact for detecting and/or counting the contacting events with the contacting device. The information may be used to determine application periods and to know, when an exchange of parts, particularly the contacts, becomes necessary. The controller may be also used to check reliability of the electrical connection and thus of the measurement.

The object is also achieved with a solar module testing apparatus for testing a solar module, comprising at least one testing station, preferably at least two testing stations, wherein the at least one testing station comprises a support for supporting a solar module, wherein the testing apparatus comprises a solar module connecting apparatus according to one of the preceding claims, wherein preferably the contacting device is arranged above the support and/or is moveable with respect to the support. As already mentioned the testing apparatus may be e.g. an electroluminescence, an I-V-curve and/or a Hipot testing apparatus.

The object is also achieved with a method of temporarily electrically connecting, by means of a solar module connecting apparatus according to the invention, a solar module with a measurement device, comprising the steps of:
(a) electrically connecting the junction unit with the solar module, preferably by means of a cable,
(b) preferably attaching the junction unit to the solar module, and
(c) bringing the contacting device from a non-contacting state into a contacting state, in which the at least one first electrical contact abuts against the at least one second electrical contact and the holding means exerts a holding force on at least one part of the junction unit, preferably on the at least one first electrical contact.

Further embodiments of the invention are indicated in the figures and in the dependent claims. The list of reference marks forms part of the disclosure. The invention will now be explained in detail by the drawings. In the drawings:
- Fig. 1: shows a solar module connecting apparatus,
- Fig. 2: shows a junction unit,
- Fig. 3: shows a connecting apparatus with a suction gripper,
- Fig. 4: shows a connecting apparatus with a magnetic gripper,
- Fig. 5: shows, on a support of a testing apparatus, a solar module having a (permanent) junction box,
- Fig. 6: shows a testing apparatus comprising testing stations,
- Fig. 7: shows in more detail the connecting apparatus of Fig. 1.

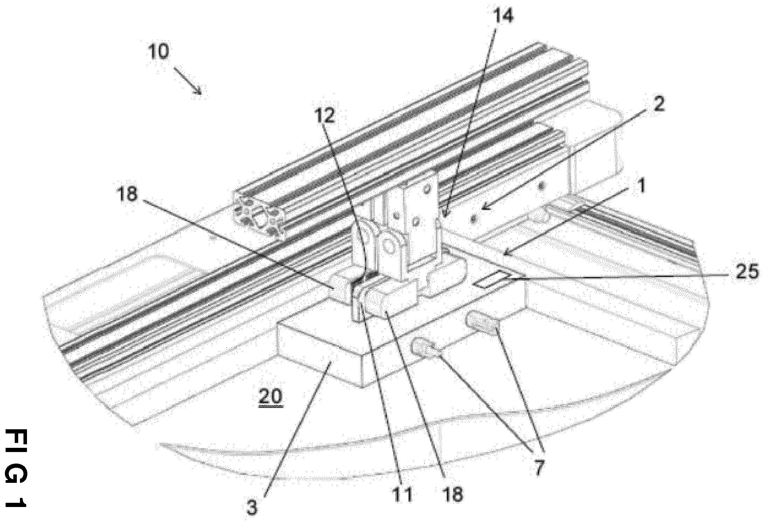

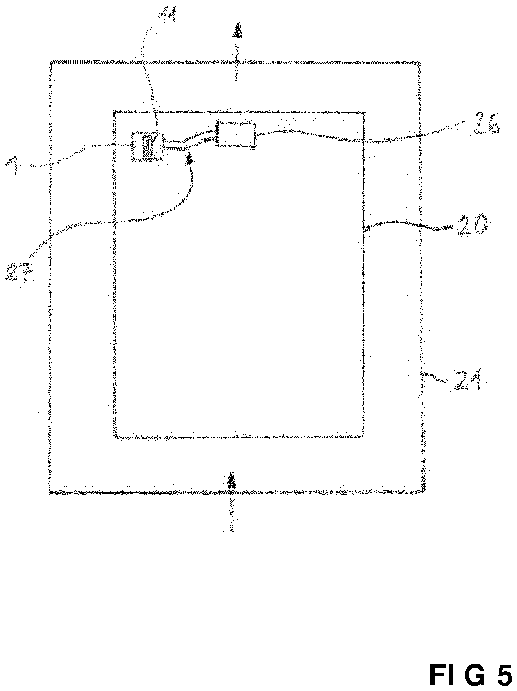

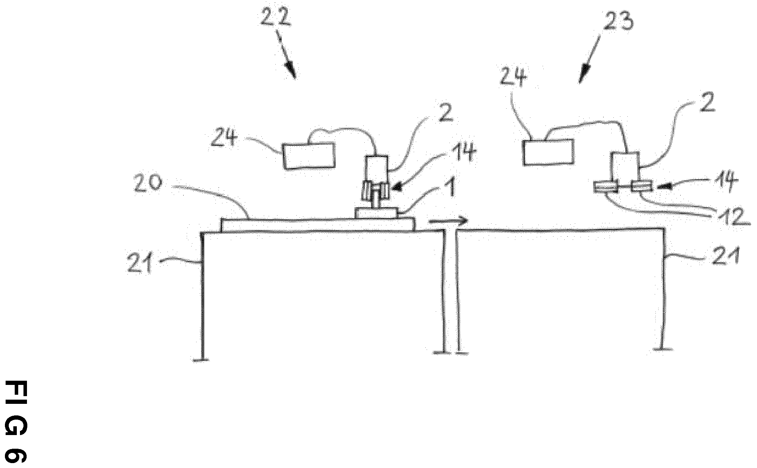

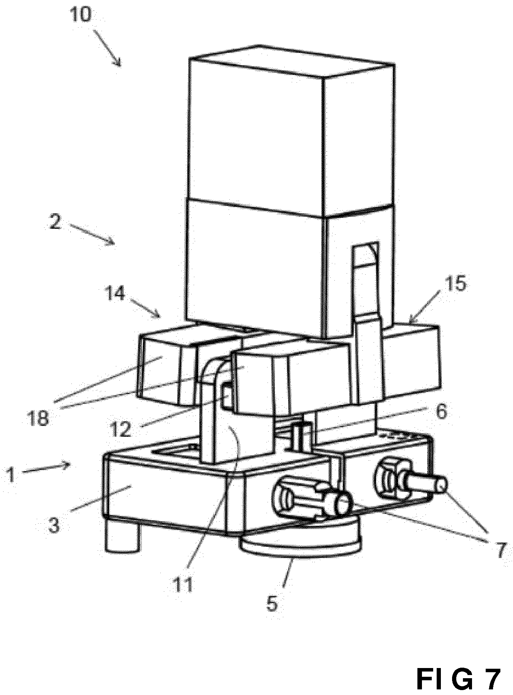

Fig. 1 - and Fig. 7 in more detail - show a solar module connecting apparatus 10 for electrically connecting a solar module 20 with a measurement device 24 (see also Figs. 5 and 6).

The connecting apparatus 10 comprises a junction unit 1 for being temporarily electrically connected to the solar module 20 (see Fig. 5) and having first electrical contacts 11. A contacting device 2 having second electrical contacts 12 is used for temporarily contacting the first electrical contacts 11 of the junction unit 1.

The contacting device 2 may be brought from a non-contacting state into a contacting state (the latter being shown in Fig. 1), in which the first electrical contacts 11 abut against the second electrical contacts 12.

The contacting device 2 comprises a holding means 14 for exerting a holding force on at least one part (here: on the first electrical contact 11) of the junction unit 1. The holding means 14 may be brought from a releasing state into a holding state.

In the preferred embodiments of Fig. 1, 3, 4, 6 and 7 the second electrical contacts 12 are formed directly on the holding means 14. The second electrical contact 12 may be detachably mounted to the holding means 14.

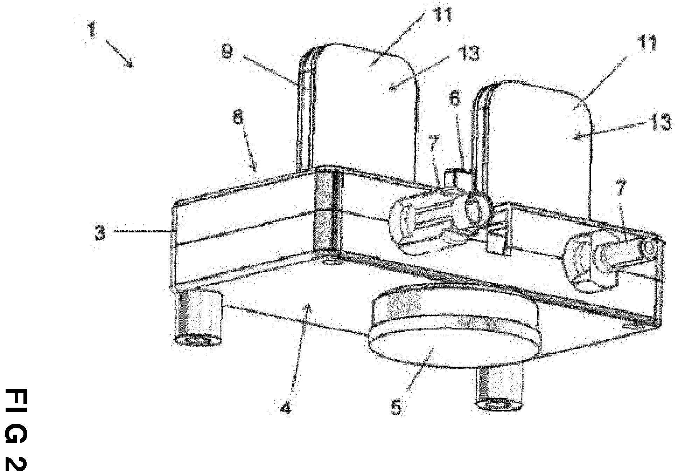

Fig. 2 shows the junction unit 1 in more detail. The junction unit has a housing 3 from which plate-shaped first electrical contacts 11 protrudes away. The height of the first electrical contacts 11 may be larger than the height of the housing 3. The width of the first electrical contacts 11 may be smaller than their height. However, in an alternate embodiment the height of the first electrical contacts 11 may be smaller than their width.

In the present embodiment the first electrical contacts 11 each have a contact surface 13 which extends transverse, here perpendicular, to the bottom 4 of the junction unit 1. The direction of the gripping force of the gripper 15 (Fig. 1 and 7) is perpendicular to the contact surfaces 13.

The junction unit 1 may also comprise fixing means 5 for temporarily fixing the junction unit 1 on a solar module 20. In Fig. 2 the fixing means 5 is formed by a suction cup. Alternatively a magnet, a hook, a snap-on device or an adhesive strip may be used. The junction unit 1 may also comprise an operating element 6 which is coupled to the fixing means 5 for activating and/or releasing the fixing means 5.

The junction unit 1 of Fig. 1 and 7 also comprises sockets 7 formed in a side wall of the junction unit 1 for connecting the junction unit 1 by means of cables 27 with the solar module 20 (Fig. 5). This is done by connecting the (temporary) junction unit 1 with a (permanent) junction box 26 of the solar module 20.

It is preferred, if the junction unit 1 comprises an identification code 25, preferably in form of a bar code and/or a RFID. The contacting device 2 may comprise a code reader. It would be also possible that the junction unit 1 comprises a controller, preferably in communication with the first electrical contact(s) 11 for detecting and/or counting the contacting events with the contacting device 2.

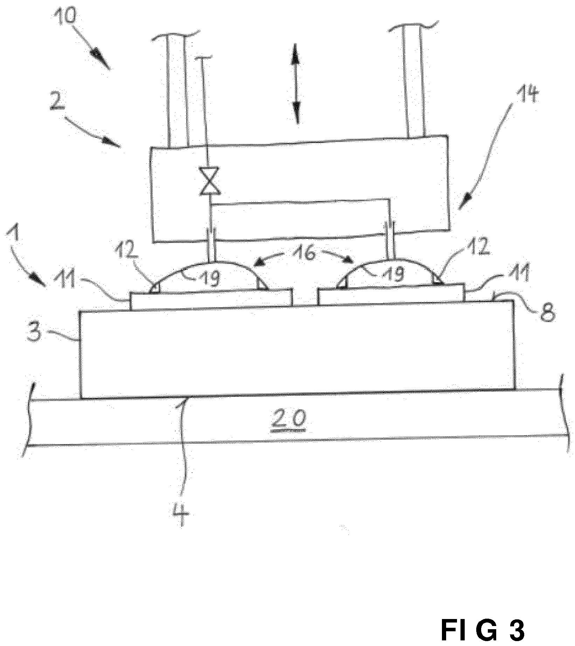

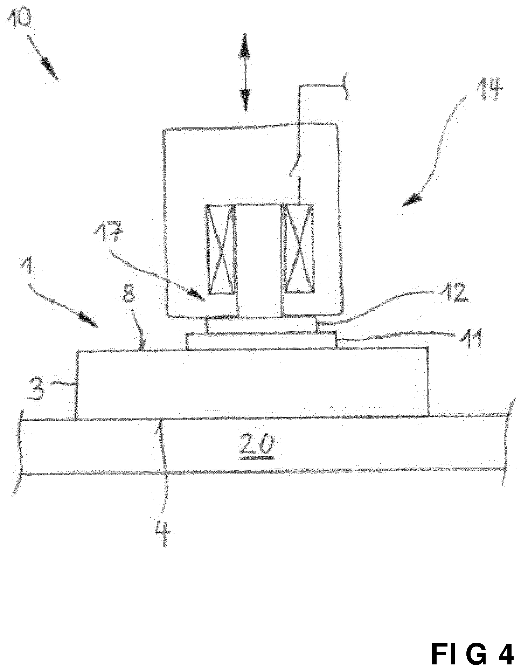

As can be seen from the Figs. 1, 3, 4 and 7 the holding means 14 may be formed by a clamping-type gripper 15 (Fig. 1 and 7) or an attracting-type gripper 16, 17 (Fig. 3 and 4).

In Fig. 1 and 7 the gripper 15 is a mechanical gripper having gripper arms 18 moveable relative to each other from a non-gripping into a gripping position. The second electrical contacts 12 are formed on the gripper arms 18 each on a side facing the other gripper arm 18.

In Fig. 3 the gripper 16 is a suction gripper. The second electrical contact 12 is formed in the circumferential region and/or on the inside of a suction cup 19 of the suction gripper.

In Fig. 4 the gripper 17 is an electromagnetic gripper. The second electrical contact 12 is part of or connected to the core of a coil of the electromagnetic gripper.

The holding means 14 comprises at least one actuator, particularly a motor, a cylinder, a valve, a controllable electrical switch or an electromagnet, for bringing the holding means 14 from the releasing state into the holding state. The gripping arms 18 in Fig 1 may be e.g. moved by means of a motor or cylinder. The suction cups 19 of Fig. 3 may be connected to a vacuum line by means of a valve. The coil of the magnetic gripper of Fig. 4 is actuated by means of a controllable switch. The actuator is in communication with a controller sending control commands to the actuator.

It is preferred if the junction unit 1 has at least two (in the embodiment of Fig. 2: at least four) independent first electrical contacts 11. Here, an electrical insulation layer 9 is formed between two first electrical contacts 11.

Similarly, the contacting device 2 may have at least two, preferably at least four, independent second electrical contacts 12.

In a preferred embodiment the contacting device 2 has at least two second electrical contacts which are associated to one of the first electrical contacts. I.e. in the contacting state the two second electrical contacts abut against the one first electrical contact. In such a manner deviations in the contact resistance may be accounted for by means of a corresponding measurement circuit.

Fig. 6 shows a solar module testing apparatus for testing a solar module 20, comprising testing stations 22, 23. The testing stations 22, 23 comprise a support 21 for supporting a solar module 20 during the measurement procedure. The testing apparatus comprises a connecting apparatus 10, wherein preferably the contacting device 2 is arranged above the support 21 and is moveable with respect to the support 21. In Fig. 3 and 4 the possibility of lowering and raising of the contacting device 2 is indicated by double-arrows.

As already mentioned above the method of electrically connecting, by means of a solar module connecting apparatus 10, a solar module 20 with a measurement device 24 comprises the steps of:
(a) placing the junction box 1 on the solar module 20 and electrically connecting the junction unit 1 with the solar module 20, preferably by means of a cable 27,
(b) preferably fixing the junction unit (1) at the solar module (20), and
(c) bringing the contacting device 2 from a non-contacting state into a contacting state, in which the first electrical contact(s) 11 abut against the second electrical contact(s) 12 and the holding means 14 exerts a holding force on at least one part of the junction unit 1, preferably on the at least one first electrical contact 11.

The invention is not restricted to these embodiments. Other variants will be obvious for the person skilled in the art and are considered to lie within the scope of the invention as formulated in the following claims. Individual features described in above specification, particularly with respect to the figures may be combined with each other to form other embodiments and/or applied mutatis mutandis to what is described in the claims and to the rest of the description.

### List of reference signs

- 1: junction unit
- 2: contacting device
- 3: housing
- 4: bottom of housing 2
- 5: fixing means
- 6: operating element
- 7: sockets
- 8: top of housing 3
- 9: electrical insulation layer
- 10: solar module connecting apparatus
- 11: first electrical contact
- 12: second electrical contact
- 13: contact surface
- 14: holding means
- 15: mechanical gripper
- 16: suction gripper
- 17: magnetic gripper
- 18: gripper arm
- 19: suction cup
- 20: solar module
- 21: support
- 22: testing station
- 23: testing station
- 24: measurement device
- 25: identification code
- 26: junction box of the solar module 20
- 27: cable

## Claims

1. A solar module connecting apparatus (10) for electrically connecting a solar module (20) with a measurement device (24), comprising
- a junction unit (1) for being temporarily electrically connected to the solar module (20) and having at least one first electrical contact (11), and
- at least one contacting device (2) having at least one second electrical contact (12) for temporarily contacting the at least one first electrical contact (11) of the junction unit (1),
wherein the contacting device (2) may be brought from a non-contacting state into a contacting state, in which the at least one first electrical contact (11) abuts against the at least one second electrical contact (12),
**characterized in that** the contacting device (2) comprises holding means (14) for exerting a holding force on at least one part, preferably on the at least one first electrical contact (11), of the junction unit (1), wherein the holding means (14) may be brought from a releasing state into a holding state.

2. A solar module connecting device according to claim 1, **wherein** the at least one second electrical contact (12) is formed on the holding means (14), wherein preferably the second electrical contact (12) is detachably mounted to the holding means (14).

3. A solar module connecting device according to claim 1 or 2, **wherein** the holding means (14) is formed by a gripper (15, 16, 17), preferably a clamping-type gripper (15) or an attracting-type gripper (16, 17).

4. A solar module connecting device according to claim 3, **wherein** the gripper (15) is a mechanical gripper having gripper arms (18) moveable relative to each other, wherein preferably the at least one second electrical contact (12) is formed on at least one of the gripper arms (18), preferably on a side facing the other gripper arm (18).

5. A solar module connecting device according to claim 3, **wherein** the gripper (16) is a suction gripper, wherein preferably the at least one second electrical contact (12) is formed in the circumferential region and/or on the inside of a suction cup (19) of the suction gripper.

6. A solar module connecting device according to claim 3, **wherein** the gripper (17) is a magnetic, preferably an electromagnetic gripper, wherein preferably the at least one second electrical contact (12) is part of or connected to the core of a coil of the electromagnetic gripper.

7. A solar module connecting device according to one of the preceding claims, **wherein** the holding means (14) comprises at least one actuator, particularly a motor, a cylinder, a valve, a controllable electrical switch or an electromagnet, for bringing the holding means (14) from the releasing state into the holding state.

8. A solar module connecting device according to one of the preceding claims, **wherein** the junction unit (1) has at least two, preferably at least four, first electrical contacts (11), wherein preferably an electrical insulation layer (9) is formed between two first electrical contacts (11), **and**/ **or** wherein the contacting device (2) has at least two, preferably at least four, second electrical contacts (12), wherein preferably an electrical insulation layer (9) is formed between two second electrical contacts (12).

9. A solar module connecting device according to one of the preceding claims, **wherein** the junction unit (1) has a housing (3) from which the at least one first electrical contact (11) protrudes away, wherein preferably the height of the at least one first electrical contact (11) is larger than the height of the housing (3) and/or the width of the at least one first electrical contact (11) is smaller than its height.

10. A solar module connecting device according to one of the preceding claims, **wherein** the at least one first electrical contact (11) has a contact surface (13) which extends transverse, preferably perpendicular, to the bottom (4) of the junction unit (1) and/or wherein the at least one first electrical contact (11) is plate-shaped.

11. A solar module connecting device according to one of the preceding claims, **wherein** the junction unit (1) comprises fixing means (5), preferably a suction cup, a magnet, a hook, a snap-on device or an adhesive strip, for temporarily fixing the junction unit (1) on a solar module (20), wherein preferably the junction unit (1) comprises an operating element (6) which is coupled to the fixing means (5) for activating and/or releasing the fixing means (5).

12. A solar module connecting device according to one of the preceding claims, **wherein** the junction unit (1) comprises sockets (7), preferably formed in a side wall of the junction unit (1), and/or cable tails for connecting the junction unit (1) by means of a cable (27) with the solar module (20).

13. A solar module connecting device according to one of the preceding claims, **wherein** the junction unit (1) comprises an identification code (25), preferably in form of a bar code and/or a RFID, wherein preferably the contacting device (2) comprises a code reader, **and**/ **or** wherein the junction unit (1) comprises a controller, preferably in communication with the at least one first electrical contact (11) for detecting and/or counting the contacting events with the contacting device (2).

14. Solar module testing apparatus for testing a solar module (20), comprising at least one testing station (22, 23), preferably at least two testing stations (22, 23), wherein the at least one testing station (22, 23) comprises a support (21) for supporting a solar module (20), wherein the testing apparatus comprises a solar module connecting apparatus (10) according to one of the preceding claims, wherein preferably the contacting device (2) is arranged above the support (21) and/or is moveable with respect to the support (21).

15. Method of temporarily electrically connecting, by means of a solar module connecting apparatus (10) according to one of the claims 1 to 13, a solar module (20) with a measurement device (24), comprising the steps of:
(a) electrically connecting the junction unit (1) with the solar module (20), preferably by means of a cable (27),
(b) preferably attaching the junction unit (1) to the solar module (20), and
(c) bringing the contacting device (2) from a non-contacting state into a contacting state, in which the at least one first electrical contact (11) abuts against the at least one second electrical contact (12) and the holding means (14) exerts a holding force on at least one part of the junction unit (1), preferably on the at least one first electrical contact (11).
